# EUROPEAN PATENT SPECIFICATION

(11) **EP 3 514 825 B1**
(45) Date of publication and mention of the grant of the patent: **29.11.2023**
(21) Application number: 18152791.2
(22) Date of filing: 22.01.2018
(51) Int. Cl.: H01L 21/67, H01L 21/677

(54) **WAFER SORTING**
SORTIERVORRICHTUNG FÜR WAFER
APPAREIL DE TRI DE GALETTES

(43) Date of publication of application: 24.07.2019
(73) Proprietor: Meyer Burger GmbH, 09337 Hohenstein-Ernstthal (DE)
(72) Inventor: Hennecke, Peter, 53909 Zülpich (DE); Starkens, Heinz, 53909 Zülpich (DE)
(74) Representative: PPR AG

(56) References cited:
- CA-A- 1 097 770
- DE-A1-102005 046 216
- US-A1- 2016 280 469

## Description

The invention relates to a wafer sorting apparatus according to the preamble of claim 1. Moreover, the invention relates to a method for sorting wafers by means of a wafer sorting apparatus.

CA 1 097 770 A discloses orienting of objects such as semiconductor wafers that are being transported along a track on an air film. The air film transportation system may comprise intersecting sections of a track having such a sensor and aspirating jets to stop the wafer in the intersection. The aspirating jets are normally off. When a wafer enters the intersection, it may pass over a sensor, the sensor opens a valve to allow air under pressure to reach the aspirating jets, stopping the wafer.

US 2016/0280469 A1 discloses a conveying apparatus that increases the conveying speed of conveyance objects, such as baggage. Acceleration/deceleration sections, each of which includes a plurality of variable-speed conveyance sections, are provided among constant-speed conveyance sections. The conveying speed of a conveyance object is continuously accelerated or decelerated while the conveyance object passes through the acceleration/deceleration sections. This changes the conveying speed from the conveying speed of the upstream constant-speed conveyance section to the conveying speed of the downstream constant-speed conveyance section.

DE 10 2005 046 216 A1 discloses a wafer sorting method. A wafer is transported by means of transport belts. A wafer is removed from a main transport belt by means of lifting a transverse transport belt.

US 4483651 A does not relate to wafer sorting, but discloses an automatic apparatus for the continuous treatment of leaf materials such as wafers of high-purity silicon semiconductors. The apparatus comprises a main transfer conveyor transporting wafers from cassettes to gas plasma reaction chambers. From the main transport conveyor, the wafers are transferred to the gas plasma reaction chambers by means of branched transfer conveyors.

A wafer transferred by the main transfer conveyor, when it arrives at the position of a pair of rollers is stopped there by means of a stopper and simultaneously lifted up by the pair of rollers to be placed on a branched wire conveyor. Because wafers need to be stopped, a continuous material flow cannot be maintained, impairing the throughput of the system.

The problem arising in prior art consists in the fact, that a large number of wafers are damaged, when being transferred from the main transport conveyor to a branching-off transport conveyor with large throughput, especially for thin wafers such as wafers that are 100µm thick or less. In order to enhance the through put the transport speed of the wafers is increased. However, this has adverse effects on the wafers: e.g. in US 4483651 A the wafers crash against the stopper.

On the other hand, DE 10 2005 046 216 A1, discloses only one branch-off. Feeding of wafers through a plurality of branch-offs at high transport speeds and high through put - and without damaging the wafers - is not solved yet.

The object of the invention is to overcome the problems mentioned above and to provide a wafer sorting apparatus which allows sorting operation at high speed or through put, respectively. At the same time, the wafers should be prevented from damage. The sorting procedure should become more reliable and adapted to preceding processes, such as wafer inspection, wafer cleaning, etc. Particularly, no wafer jam should occur before or within the sorting apparatus. Rather, the wafer sorting apparatus should operate with preceding processes "just in time".

The object is achieved by a wafer sorting apparatus according to claim 1.

The decelerating conveyor comprises at least two sections,
wherein a first section extends upstream of the branching-off conveyor and/or wherein the decelerating conveyor comprises at least one conveying belt which between a first section and a further section is guided at least once below a transport plane of the branching-off conveyor.

The speed of the decelerating conveyor is only decreased if an approaching wafer is designated to leave the main transport path at that branch-off (to a branching-off transport path). In the case, a wafer is designated to pass the branch-off - i.e. without leaving the main transport path - the speed of the decelerating conveyor of that branch-off is preferably not decreased. In such a way the through-put of wafers may be increased.

The term "selectively" refers to the fact, that (only) selected wafers approaching a certain branch-off are decelerated. Wafers that are not intended to leave the main transport path at the respective branch-off do not have to be decelerated, but may proceed at constant or increasing speed, e.g. towards a subsequent branch-off. Selection of wafers is done e.g. by means of a wafer inspection device, which classifies the wafers by quality characteristics. However, selection can also be done independent of quality characteristics. E.g. every second, third, fourth, etc., wafer may be removed from the main transport path at a certain branch-off.

At least one branching-off transport path extends from the branch-off. It is preferred, if two branching-off transport path extend from a branch-off in opposite directions.

The wafer sorting apparatus may comprise at least two, preferably a plurality of, decelerating conveyors which are arranged one after the other along the main transport path. In this embodiment at least two, preferably a plurality of, branch-offs are provided in the main transport path, wherein each (of the at least two branch-offs) is associated with a decelerating conveyor. The control device may be configured to separately control these decelerating conveyors associated to different branch-offs. With other words: the actual speed of different decelerating conveyors may be controlled independent of the speed of the other decelerating conveyor(s).

The decelerating conveyors each have its own drive, which can be controlled individually (by the control device).

Preferably, the at least one branch-off comprises a branching-off conveyor, which forms a section of the branching-off transport path, wherein the transport direction of the branching-off conveyor is transverse, preferably perpendicular, to the transport direction of the decelerating conveyor. At the end of the branching-off transport paths collecting means, such as containers, for receiving the sorted wafers may be provided.

Preferably, the main transport path comprises at least two branch-offs arranged one after the other along the main transport path, wherein each of the at least two branch-offs comprises a decelerating conveyor forming a section of the main transport path and being in communication with the control device, wherein the control device is configured to control, preferably to separately control, the decelerating conveyors of the at least two branch-offs, such that the decelerating conveyors may be driven at different speeds, decelerations and/or accelerations, wherein preferably the decelerating conveyor of a branch-off may be driven at a different speed, deceleration and/or acceleration than the decelerating conveyor of another branch-off. Here, the decelerating conveyors of different branch-offs may be operated independently of each other. Each branch-off of the at least two branch-offs has a separate decelerating conveyor. The decelerating conveyors may have - at the same time - different speed and/or deceleration and/or acceleration. In such a way, the speed of a decelerating conveyor may be decreased in order to decelerate a wafer designated to leave the main transport path at that branch-off. The speed of that decelerating conveyor may be adjusted independently of the speed(s), of the other decelerating conveyor(s), which is/are associated with (an)other branch-off(s).

Preferably, the decelerating conveyor and/or the branching-off conveyor extend(s) at least in an area of the branch-off, preferably through the branch-off. In such a way the speed of the wafers may be influenced in the immediate vicinity of the branch-off.

In a preferred embodiment the control device is in communication with the branching-off conveyor and is configured to accelerate, preferably to continuously accelerate, a wafer on the branching off conveyor by increasing the transport speed of the branching-off conveyor, preferably starting at zero speed.

In a preferred embodiment, at least one further conveyor is arranged downstream of the branching-off conveyor (i.e. wafers leaving the main transport path are transferred from the branching off conveyor to the further conveyor). It preferred if the control device is in communication with the branching-off conveyor and with the at least one further conveyor. The control device may be configured to separately control the speed of the branching-off conveyor and the speed of the at least one further conveyor, i.e. their transport speeds may be controlled independently from each other.

The decelerating conveyor comprises at least two sections, wherein in an embodiment of the invention a first section extends upstream of the branching-off conveyor. This section contributes most to the deceleration of an approaching wafer.

Preferably, a further section of the decelerating conveyor extends downstream of the branching-off conveyor. This section contributes to the deceleration at a late stage of decelerating, but ensures a defined movement of the wafer, particularly prevents the wafer from changing its orientation.

Preferably, a further section of the decelerating conveyor extends between conveying belts of the branching-off conveyor. This section receives the wafer at an intermediate stage of deceleration and ensures a reliable and defined deceleration or stop of the wafer in the center of the branch-off.

In an embodiment of the invention, the decelerating conveyor comprises at least one conveying belt which between the first section and a further section is guided at least once below a transport plane of the branching-off conveyor. In such a way, the decelerating conveyor may be formed by at least one, preferably at least two, continuous belts. This ensures that the first section and the at least one further section are operated at the same speed.

Preferably, the wafer transport device comprises at least one accelerating conveyor forming a section of the main transport path, wherein the accelerating conveyor is arranged upstream of a decelerating conveyor and is in communication with the control device, wherein the control device is configured to accelerate a wafer by increasing the speed of the accelerating conveyor, wherein preferably the accelerating conveyor is integrally formed with the decelerating conveyor. The accelerating conveyor temporarily accelerated the wafers in order to - at least partially - gain (in an upstream region) that time, which is subsequently consumed (in a downstream region) by the decelerating procedure of the decelerating conveyor. Such an accelerating phase further increases through put of wafers.

Preferably, the wafer transport device comprises a shifting device
by means of which the transport plane of the decelerating conveyor and the transport plane of the branching-off conveyor may be shifted relative to each other in vertical direction,
and/or by means of which the transport plane of the decelerating conveyor and the transport plane of the accelerating conveyor may be shifted relative to each other in vertical direction.

By the shifting operation, the wafers may be easily transferred to the other conveyor (e.g. branching-off conveyor). In the shifted state an edge of a wafer may overlap with an edge of a subsequent wafer. The transport plane is that plane on which the transported wafers lie on.

Preferably, the shifting device is in communication with the control device, wherein the control device is configured to control the shifting device, such that the transport planes are shifted relative to each other after the transport speed of a wafer approaching the branch-off is decelerated below a threshold or has reached zero. Such a procedure guarantees that no (or only minor) friction occurs between wafer and conveyor.

Preferably, the transport plane of the decelerating conveyor may be lowered relative to the transport plane of the branching-off conveyor, and/or wherein the transport plane of the decelerating conveyor may be lowered relative to the transport plane of the accelerating conveyor. When lowering the decelerating conveyor, the wafer becomes received by the branching-off conveyor. The branching-off conveyor may be driven at constant speed or may be accelerated when the wafer rests upon the branching-off conveyor.

Preferably, in a first relative position, the transport plane of the accelerating conveyor and the transport plane of the decelerating conveyor lie essentially within the same plane.

Preferably, the transport plane of the branching-off conveyor is arranged at a lower height than the transport plane of the accelerating conveyor.

Preferably, the transport plane of the accelerating conveyor and the transport plane of the branching-off transport path are shifted in vertical direction, preferably by at least 1cm, more preferred by at least 3cm, and/or wherein the transport plane of the accelerating conveyor and the transport plane of the decelerating conveyor and the transport plane of the at least one branching-off transport path are essentially horizontal.

Preferably, the accelerating conveyor and/or the decelerating conveyor and/or the branching-off conveyor comprises at least one circulating belt, preferably at least two parallel extending circulating belts.

The object is also achieved with a method for sorting wafers by means of an inventive wafer sorting apparatus, preferably according to one of the preceding embodiments, comprising the steps of:
(a) transporting wafers one after the other along a main transport path,
(d) selectively transferring wafers from the main transport path to at least one branching-off transport path via at least one branch-off provided in the main transport path,
characterized in that the method between step (a) and step (d) further comprises the step of:
   (c) decelerating wafers approaching the branch-off at which they leave the main transport path.

As already mentioned above, decelerating the wafers prevents them from damages when changing the transport direction. In the case of at least two branch-offs different wafers may be transported at different speeds. A first wafer approaching a first branch-off may be transported through the first branch-off without deceleration. The first wafer travels along the first transport path and approaches a second branch-off. The first wafer will be decelerated at the second branch-off will leave the main transport path at the second branch-off. In the meantime, a second wafer upstream of the first wafer approaches the first branch-off and is decelerated there, in order to leave the main transport path at the first branch-off. The (first and second) wafers may be decelerated independent of each other at the branch-off at which they leave the main transport path. With other words: deceleration of a first wafer is done at a certain branch-off without influencing the speed of a second wafer approaching another branch-off.

Preferably, step (c) is performed by means of at least one decelerating conveyor forming a section of the main transport path and being in communication with a control device, wherein the control device selectively decelerates a wafer approaching a branch-off by decreasing the speed of the at least one decelerating conveyor.

Preferably, the main transport path comprises at least two branch-offs arranged one after the other along the main transport path, wherein each of the at least two branch-offs comprises a decelerating conveyor forming a section of the main transport path and being in communication with the control device, wherein the control device separately controls the decelerating conveyors of the at least two branch-offs, such that the decelerating conveyors may be driven at different speeds, decelerations and/or accelerations, wherein preferably the decelerating conveyor of a branch-off may be driven at a different speed, deceleration and/or acceleration than the decelerating conveyor of another branch-off.

Preferably, in step (c) the wafers are decelerated from a first transport speed to a speed, which is smaller than 30%, preferably smaller than 10%, of the first transport speed, when having reached the branch-off position, wherein preferably the first transport speed is that speed at which the wafers are transferred to the decelerating conveyor.

Preferably, in step (c) the wafers are decelerated to zero speed, when having reached the branch-off position (i.e. that position, in which the wafers are transferred to the branching-off conveyor and in which the transport direction of the wafers changes).

Preferably, the method between step (a) and step (c) further comprises the step of:
(b) accelerating the wafers. By means of accelerating the wafers, a time gain is obtained in order to compensate the subsequent time loss due to deceleration.

Preferably, step (a) is performed by means of a first conveyor and step (c) by means of a second conveyor, wherein the transport speed of the second conveyor is controlled independently of the transport speed of the first conveyor. The first conveyor may be a conveyor of the wafer sorting apparatus or a conveyor of an inspection device arranged upstream of the wafer sorting apparatus or a separate conveyor.

Preferably, step (c) is performed by reducing, preferably continuously reducing, the transport speed of the decelerating conveyor. Continuously reducing the speed (e.g. by a speed ramp, such as a linear ramp) a smooth treatment of the wafers in the area of the branch-off is achieved.

Preferably, step (d) comprises lowering the transport plane of the decelerating conveyor at least to the level of the transport plane of a branching-off conveyor or rising the transport plane of the branching-off conveyor at least to, preferably beyond, the level of the transport plane of the decelerating conveyor, wherein the transport direction of the branching-off conveyor is transverse, preferably perpendicular, to the transport direction of the decelerating conveyor, wherein preferably the branching-off conveyor traverses the decelerating conveyor.

Preferably, the transport plane of the decelerating conveyor and the transport plane of the branching-off conveyor are shifted relative to each other after, preferably only after, the transport speed of a wafer approaching the branch-off is decelerated below a threshold or has reached zero.

Further embodiments of the invention are indicated in the figures and in the dependent claims. The list of reference marks forms part of the disclosure. The invention will now be explained in detail by the drawings. In the drawings:
- Fig. 1: shows an inventive wafer sorting apparatus,

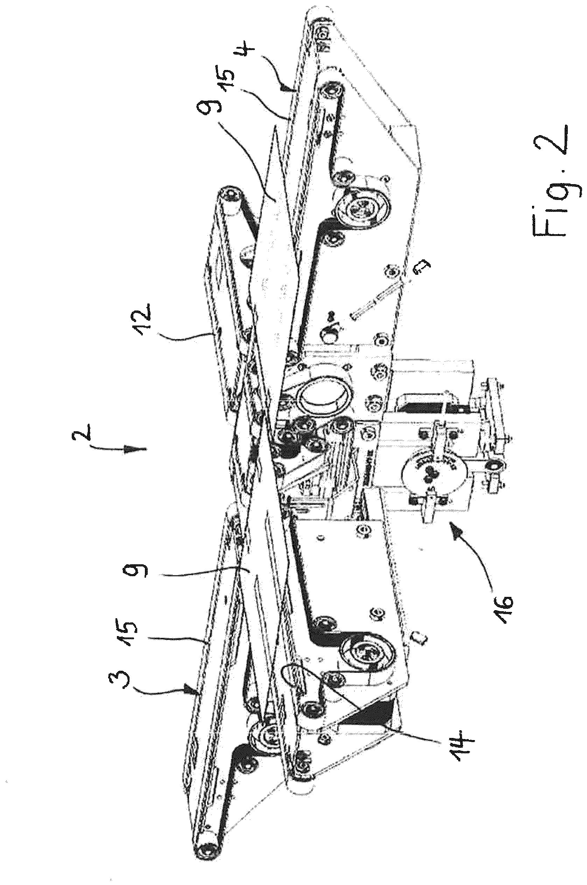

- Fig. 2: shows a branch-off in more detail,
- Fig. 3: shows a control device in communication with the conveyors of the wafer sorting apparatus,
- Fig. 4: shows the speeds of a wafer on different conveyors,
- Fig. 5: shows the decelerating conveyor having three sections, and
- Fig. 6: shows the lowering procedure of the decelerating conveyor.

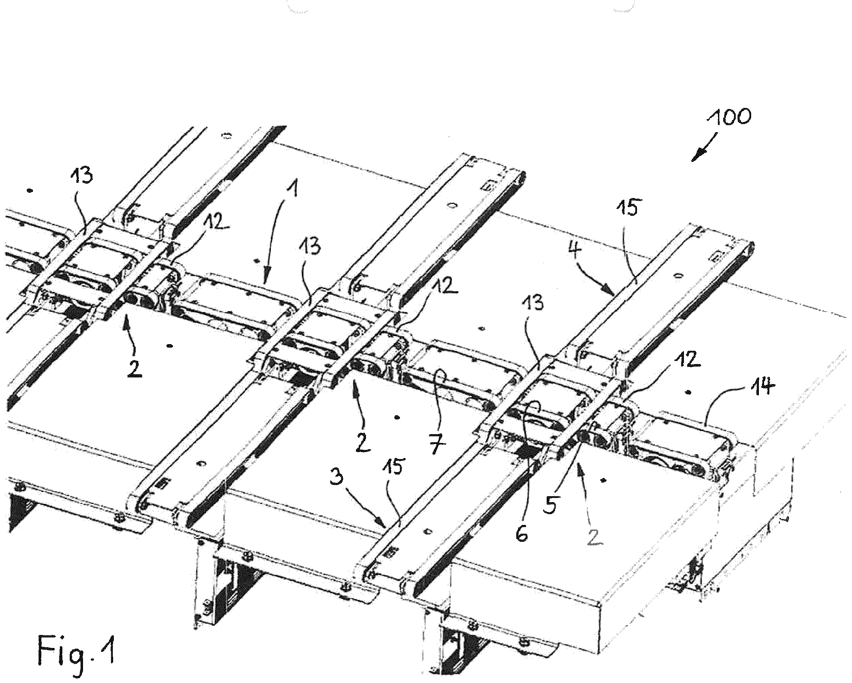

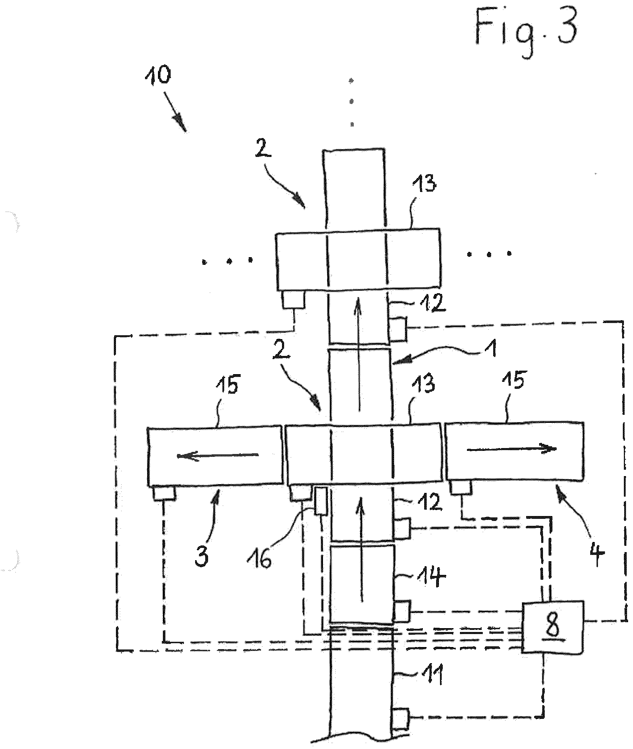

Fig. 1 shows a wafer sorting apparatus 100 having a wafer transport device 10 (see Fig. 3) which comprises: a main transport path 1 comprising at least one branch-off 2 - in the present embodiment three branch-offs 2 -, at least one branching-off transport path 3, 4 extending from the at least one branch-off 2 and a control device 8 (Fig. 3) for controlling the transport of wafers 9.

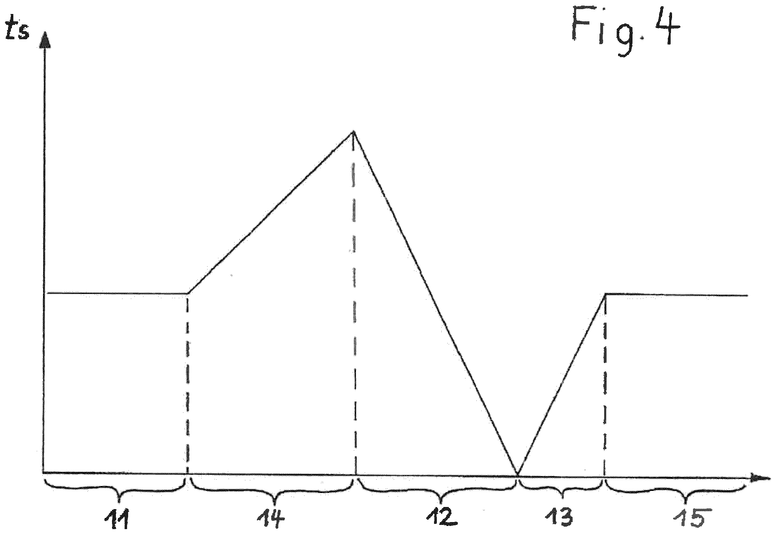

The branch-offs 2 each comprises a decelerating conveyor 12 forming a section of the main transport path 1 and being in communication with the control device 8. The control device 8 is configured to selectively decelerate a wafer 9 approaching the respective branch-off 2 by decreasing the speeds of the decelerating conveyor 12 (Fig. 4).

The branch-offs 2 each comprise a branching-off conveyor 13, which forms a section of the branching-off transport path 3, 4, wherein the transport direction of the branching-off conveyor 13 is transverse - in the present embodiment perpendicular - to the transport direction of the decelerating conveyor 12. The branching-off conveyor 13 may have a constant speed or accelerate once it supports a wafer 9. The branching-off transport paths 3, 4 each comprise further conveyors 15. At the end of each branching-off transport path 3, 4 collecting means (not shown), such as containers, for receiving the sorted wafers 9 may be provided.

It is preferred if the main transport path 1 comprises at least two branch-offs 2 arranged one after the other along the main transport path 1. Each of the at least two branch-offs 2 comprises a decelerating conveyor 12 forming a section of the main transport path 1 and being in communication with the control device 8. The decelerating conveyors 12 each have its own drive, which can be controlled individually by the control device 8.

The control device 8 is configured to control, preferably to separately control, the decelerating conveyors 12 of the at least two branch-offs 2. In such a way, the decelerating conveyors 12 and/or branching-off conveyors 13 may be driven at different speeds, decelerations and/or accelerations, wherein preferably the decelerating conveyor 12 of a branch-off 2 may be driven at a different speed, deceleration and/or acceleration than the decelerating conveyor 12 of another branch-off 2.

As can be seen from Fig. 1 the decelerating conveyor 12 and the branching-off conveyor 13 extend through the branch-off 2.

In the embodiments of Fig. 1, 5 and 6 the decelerating conveyor 12 comprises at least two sections 5, 6, 7. A first section 5 of the decelerating conveyor 12 extends upstream of the branching-off conveyor 13. A second section 6 extends between two conveying belts of the branching-off conveyor 13. A third section 7 extends downstream of the branching-off conveyor 13.

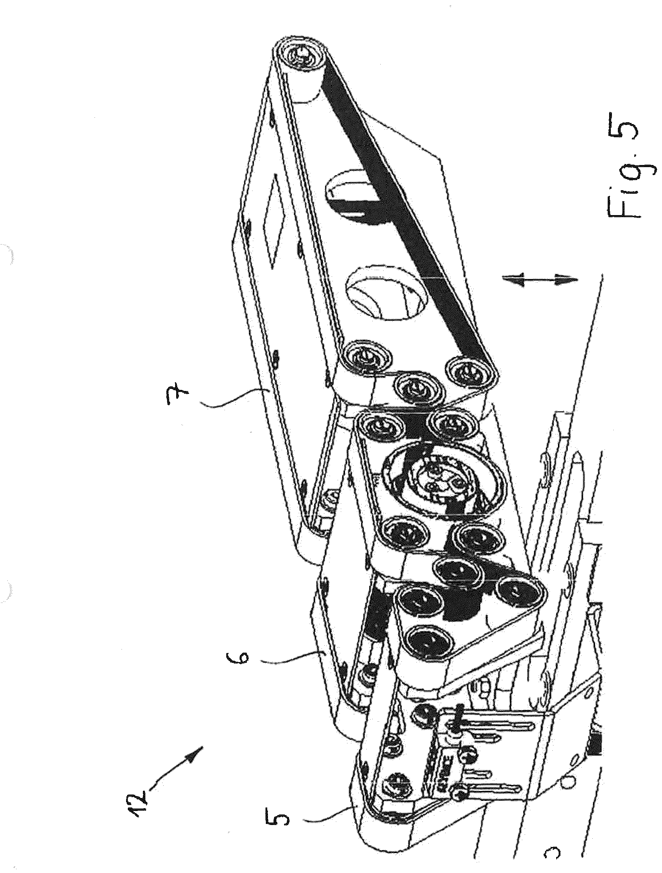

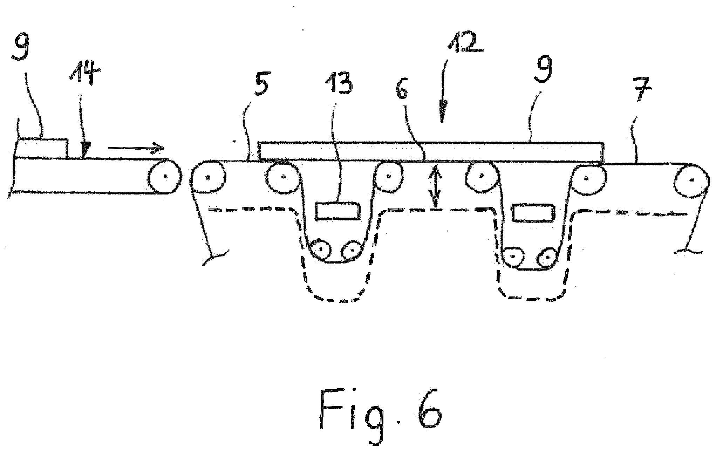

In the present embodiment, the decelerating conveyor 12 comprises at least one conveying belt which between the first section 5 and the second section 6 and between the second section 6 and the third section 7 is guided below the transport plane of the branching-off conveyor 13 (Fig. 5 and 6).

The wafer transport device 10 may further comprise at least one accelerating conveyor 14 forming a section of the main transport path 1. The accelerating conveyor 14 is arranged upstream of a decelerating conveyor 12 (preferably at the beginning of the wafer sorting device 100) and is in communication with the control device 8. The control device 8 is configured to accelerate a wafer 9 by increasing the speed of the accelerating conveyor 14. The accelerating conveyor 14 may be integrally formed with a decelerating conveyor 12.

In a preferred embodiment at least one further conveyor 15 is arranged downstream of the branching-off conveyor 13 (i.e. wafers 9 leaving the main transport path 1 are transferred from the branching off conveyor 13 to the further conveyor 15). It is preferred, if the control device 8 is in communication with the branching-off conveyor(s) 13 and with the at least one further conveyor 15. The control device 8 may be configured to separately control the speed of the branching-off conveyor 13 and the speed of the at least one further conveyor 15, i.e. their transport speeds may be controlled independently of each other.

The wafer transport device 10 may comprise a shifting device 16 by means of which the transport plane of the decelerating conveyor 12 and the transport plane of the branching-off conveyor 13 may be shifted relative to each other in vertical direction (Fig. 6).

It would be also possible to shift the transport plane of the decelerating conveyor 12 and the transport plane of the accelerating conveyor 14 relative to each other in vertical direction.

The shifting device 16 (schematically shown in Fig. 3) is in communication with the control device 8. The control device 8 is configured to control the shifting device 16, such that the transport planes are shifted relative to each other after, preferably only after, the transport speed of a wafer 9 approaching the branch-off 2 is decelerated below a threshold or has reached zero.

As can be seen from Fig. 6 the transport plane of the decelerating conveyor 12 may be lowered relative to the transport plane of the branching-off conveyor 13. As a consequence, the transport plane of the decelerating conveyor 12 is lowered relative to the transport plane of the accelerating conveyor 14.

As can be seen from Fig. 6, in a first relative position (full line), the transport plane of the accelerating conveyor 14 and the transport plane of the decelerating conveyor 12 lie essentially within the same plane. In a second, lowered position (dashed lines) the transport plane of the decelerating conveyor lies below the transport plane of the accelerating conveyor 14.

The transport plane of the branching-off conveyor 13 is arranged at a lower height than the transport plane of the accelerating conveyor 14.

The transport plane of the accelerating conveyor 14 and the transport plane of the branching-off transport path 3, 4 may be shifted in vertical direction, preferably by at least 1cm, more preferred by at least 3cm. It is preferred if the transport plane of the accelerating conveyor 14 and the transport plane of the decelerating conveyor 12 and the transport plane of the at least one branching-off transport path 3, 4 are essentially horizontal.

The method for sorting wafers 9 by means of a wafer sorting apparatus 100 comprising the steps of:
(a) transporting wafers 9 one after the other along a main transport path 1,
(d) selectively transferring wafers 9 from the main transport path 1 to at least one branching-off transport path 3, 4 via at least one branch-off 2 provided in the main transport path 1.

Between step (a) and step (d) the method further comprises the step of: (c) decelerating wafers 9 approaching the branch-off 2 at which they leave the main transport path 1.

Step (c) is preferably performed by reducing, preferably continuously reducing, the transport speed of a decelerating conveyor 12.

As already mentioned above, it is preferred, if the main transport path 1 comprises at least two branch-offs 2 arranged one after the other along the main transport path 1. Each of the at least two branch-offs 2 comprises a decelerating conveyor 12 forming a section of the main transport path 1 and is in communication with the control device 8. The control device 8 separately controls the decelerating conveyors 12 of the at least two branch-offs 2.

In general, the embodiment reads as follows: Method according to which step (c) is performed by means of at least one decelerating conveyor 12 forming a section of the main transport path 1 and being in communication with a control device 8, wherein the control device 8 selectively decelerates a wafer approaching said a branch-off 2 by decreasing the speed of the at least one decelerating conveyor 12.

In step (c) the wafers may be decelerated from a first transport speed to a speed, which is smaller than 30%, preferably smaller than 10%, of the first transport speed, when having reached the branch-off position.

It is preferred if the wafers 9 are decelerated to zero speed, when having reached the branch-off position (see Fig. 4).

The method may between step (a) and step (c) further comprise the step of: (b) accelerating the wafers 9.

Step (a) may be performed by means of a first conveyor 11 (Fig. 3 and 4) and step (c) by means of a decelerating conveyor 12, wherein the transport speed of the decelerating conveyor 12 is controlled independently of the transport speed of the first conveyor 11.

The first conveyor 11 may be part of the sorting apparatus. Alternatively the first conveyor may be part of an inspection device or may be a separate conveyor.

Step (d) may comprise lowering the transport plane of the decelerating conveyor 12 at least to the level of the transport plane of a branching-off conveyor 13 or rising the transport plane of the branching-off conveyor 13 at least to, preferably beyond, the level of the transport plane of the decelerating conveyor 12. Preferably, the transport plane of the decelerating conveyor 12 and the transport plane of the branching-off conveyor 13 are shifted relative to each other after, preferably only after, the transport speed of a wafer 9 approaching the branch-off 2 is decelerated below a threshold or has reached zero.

Fig. 4 illustrates an aspect of the invention, namely the speed of a wafer 9 when transported by the individual conveyors. On the first conveyor 11 the wafers 9 may be transported at constant speed. Accelerating conveyor 14 accelerates the wafers 9. Decelerating conveyor 12 decelerates the wafers 9, preferably stop the wafers (i.e. essentially zero speed). The branching-off conveyor 13 changes the transport direction of the wafers 9 and accelerates the wafers 9 again. The further conveyors 15 of the branching-off transport paths 3, 4 may transport the wafers 9 at constant speed (e.g. toward collecting containers).

The invention is not restricted to the embodiments described above. Other variants will be obvious for the person skilled in the art and are considered to lie within the scope of the invention as formulated in the following claims. The invention is defined by the appended claims.

Individual features described in all parts of the above specification, particularly with respect to the figures may be combined with each other to form other embodiments and/or applied mutatis mutandis to what is described in the claims and to the rest of the description, even if the features are described in respect to or in combination with other features.

### List of reference signs

- 1: main transport path
- 2: branch-off
- 3: branching-off transport path
- 4: branching-off transport path
- 5: first section
- 6: further (second) section
- 7: further (third) section
- 8: control device
- 9: wafer
- 10: wafer transport device
- 11: first conveyor
- 12: decelerating conveyor
- 13: branching-off conveyor
- 14: accelerating conveyor
- 15: further (branching) conveyor
- 16: shifting device
- 100: wafer sorting apparatus
- ts: transport speed of a wafer

## Claims

1. Wafer sorting apparatus (100) having a wafer transport device (10) which comprises
- a main transport path (1) comprising at least one branch-off (2),
- at least one branching-off transport path (3, 4) extending from the at least one branch-off (2) and
- a control device (8) for controlling the transport of wafers (9),
wherein the at least one branch-off (2) comprises a decelerating conveyor (12) forming a section of the main transport path (1) and being in communication with the control device (8), wherein the control device (8) is configured to selectively decelerate a wafer (9) approaching said branch-off (2) by decreasing the transport speed of the decelerating conveyor (12),
**characterized in that** the decelerating conveyor (12) comprises at least two sections (5, 6, 7),
wherein a first section (5) extends upstream of a branching-off conveyor(13) and/or wherein the decelerating conveyor (12) comprises at least one conveying belt which between a first section (5) and a further section (6, 7) is guided at least once below a transport plane of the branching-off conveyor (13).

2. Wafer sorting apparatus (100) according to claim 1, wherein the branching-off conveyor (13) is comprised in the at least one branch-off (2) and forms a section of the branching-off transport path (3, 4), wherein the transport direction of the branching-off conveyor (13) is transverse, preferably perpendicular, to the transport direction of the decelerating conveyor (12).

3. Wafer sorting apparatus (100) according to claim 1 or 2, wherein the main transport path (1) comprises at least two branch-offs (2) arranged one after the other along the main transport path (1), wherein each of the at least two branch-offs (2) comprises a decelerating conveyor (12) forming a section of the main transport path (1) and being in communication with the control device (8), wherein the control device (8) is configured to control, preferably to separately control, the decelerating conveyors (12) of the at least two branch-offs (2), such that the decelerating conveyors (12) may be driven at different speeds, decelerations and/or accelerations, wherein preferably the decelerating conveyor (12) of a branch-off (2) may be driven at a different speed, deceleration and/or acceleration than the decelerating conveyor (12) of another branch-off (2).

4. Wafer sorting apparatus (100) according to one of the preceding claims, wherein the decelerating conveyor (12) and/or the branching-off conveyor (13) extend(s) at least in an area of the branch-off (2), preferably through the branch-off (2).

5. Wafer sorting apparatus (100) according to one of the preceding claims,
wherein a further section (7) of the decelerating conveyor (12) extends downstream of the branching-off conveyor (13)
and/or wherein a further section (6) of the decelerating conveyor (12) extends between conveying belts of the branching-off conveyor (13)
and/or wherein the accelerating conveyor and/or the decelerating conveyor and/or the branching-off conveyor comprises at least one circulating belt, preferably at least two parallel extending circulating belts.

6. Wafer sorting apparatus (100) according to one of the preceding claims, wherein the wafer transport device comprises at least one accelerating conveyor (14) forming a section of the main transport path (1), wherein the accelerating conveyor (14) is arranged upstream of a decelerating conveyor (12) and is in communication with the control device (8), wherein the control device (8) is configured to accelerate a wafer by increasing the speed of the accelerating conveyor (14), and/or wherein the accelerating conveyor (14) is integrally formed with the decelerating conveyor (12).

7. Wafer sorting apparatus (100) according to one of the one of the preceding claims, wherein the wafer transport device (10) comprises a shifting device (16)
by means of which the transport plane of the decelerating conveyor (12) and the transport plane of the branching-off conveyor (13) may be shifted relative to each other in vertical direction,
and/or by means of which the transport plane of the decelerating conveyor (12) and the transport plane of the accelerating conveyor (14) may be shifted relative to each other in vertical direction,
wherein preferably the shifting device (16) is in communication with the control device (8), wherein the control device (8) is configured to control the shifting device (16), such that the transport planes are shifted relative to each other after, preferably only after, the transport speed of a wafer approaching the branch-off (2) is decelerated below a threshold or has reached zero.

8. Wafer sorting apparatus (100) according to one of the preceding claims, wherein the transport plane of the decelerating conveyor (12) may be lowered relative to the transport plane of the branching-off conveyor (13),
and/or wherein the transport plane of the decelerating conveyor (12) may be lowered relative to the transport plane of the accelerating conveyor (14).

9. Wafer sorting apparatus (100) according to one of the preceding claims, wherein in a first relative position, the transport plane of the accelerating conveyor (14) and the transport plane of the decelerating conveyor (12) lie essentially within the same plane,
and/or wherein the transport plane of the branching-off conveyor (13) is arranged at a lower height than the transport plane of the accelerating conveyor (14).

10. Method for sorting wafers (9) by means of a wafer sorting apparatus (100), according to one of the preceding claims, comprising the steps of:
(a) transporting wafers (9) one after the other along a main transport path (1),
(d) selectively transferring wafers (9) from the main transport path (1) to at least one branching-off transport path (3, 4) via at least one branch-off (2) provided in the main transport path (1),
**characterized in that** the method between step (a) and step (d) further comprises the step of:
(c) decelerating wafers (9) approaching the branch-off (2) at which they leave the main transport path (1)
wherein preferably step (c) is performed by reducing, preferably continuously reducing, the transport speed of a decelerating conveyor (12).

11. Method according to claim 10, wherein the main transport path (1) comprises at least two branch-offs (2) arranged one after the other along the main transport path (1), wherein each of the at least two branch-offs (2) comprises a decelerating conveyor (12) forming a section of the main transport path (1) and being in communication with the control device (8), wherein the control device (8) separately controls the decelerating conveyors of the at least two branch-offs (2), such that the decelerating conveyors (12) may be driven at different speeds, decelerations and/or accelerations, wherein preferably the decelerating conveyor (12) of a branch-off (2) may be driven at a different speed, deceleration and/or acceleration than the decelerating conveyor (12) of another branch-off (2).

12. Method according to claim 10 or 11,
wherein in step (c) the wafers are decelerated from a first transport speed to a speed, which is smaller than 30%, preferably smaller than 10%, of the first transport speed, when having reached the branch-off position, wherein preferably the first transport speed is that speed at which the wafers (9) are transferred to the decelerating conveyor (12), and/or wherein in step (c) the wafers are decelerated to zero speed, when having reached the branch-off position.

13. Method according to one of the claims 10 to 12, wherein the method between step (a) and step (c) further comprises the step of: (b) accelerating the wafers.

14. Method according to one of the claims 10 to 13, wherein step (a) is performed by means of a first conveyor (11) and step (c) by means of a decelerating conveyor (12), wherein the transport speed of the decelerating conveyor (12) is controlled independently of the transport speed of the first conveyor (11).

15. Method according to one of the claims 10 to 14, wherein step (d) comprises lowering the transport plane of the decelerating conveyor (12) at least to the level of the transport plane of a branching-off conveyor (13) or rising the transport plane of the branching-off conveyor (13) at least to, preferably beyond, the level of the transport plane of the decelerating conveyor (12), wherein the transport direction of the branching-off conveyor (13) is transverse, preferably perpendicular, to the transport direction of the decelerating conveyor (12),
wherein preferably the transport plane of the decelerating conveyor (12) and the transport plane of the branching-off conveyor (13) are shifted relative to each other after, preferably only after, the transport speed of a wafer approaching the branch-off (2) is decelerated below a threshold or has reached zero
and/or wherein preferably the branching-off conveyor (13) traverses the decelerating conveyor (12).

## Patentansprüche

1. Wafer-Sortiervorrichtung (100), die eine Wafer-Transportvorrichtung (10) aufweist, die umfasst:
- einen Haupttransportpfad (1), der mindestens eine Abzweigung (2) umfasst,
- mindestens einen Abzweig-Transportpfad (3, 4), der sich von der mindestens einen Abzweigung (2) erstreckt, und
- eine Steuervorrichtung (8) zum Steuern des Transports von Wafern (9),
wobei die mindestens eine Abzweigung (2) eine verlangsamende Förderstrecke (12) umfasst, die einen Abschnitt des Haupttransportpfads (1) bildet und mit der Steuervorrichtung (8) kommuniziert, wobei die Steuervorrichtung (8) so konfiguriert ist, dass sie einen Wafer (9), der sich der Abzweigung (2) nähert, durch Verringern der Transportgeschwindigkeit der verlangsamenden Förderstrecke (12) selektiv verlangsamt,
**dadurch gekennzeichnet, dass** die verlangsamende Förderstrecke (12) mindestens zwei Abschnitte (5, 6, 7) umfasst,
wobei sich ein erster Abschnitt (5) stromaufwärts einer Abzweig-Förderstrecke (13) erstreckt, und/oder wobei die verlangsamende Förderstrecke (12) mindestens ein Förderband umfasst, das zwischen einem ersten Abschnitt (5) und einem weiteren Abschnitt (6, 7) mindestens einmal unterhalb einer Transportebene der Abzweig-Förderstrecke (13) entlang geführt wird.

2. Wafer-Sortiervorrichtung (100) nach Anspruch 1, wobei die Abzweig-Förderstrecke (13) in der mindestens einen Abzweigung (2) enthalten ist und einen Abschnitt des Abzweig-Transportpfades (3, 4) bildet, wobei die Transportrichtung der Abzweig-Förderstrecke (13) quer, bevorzugt im rechten Winkel, zur Transportrichtung der verlangsamenden Förderstrecke (12) verläuft.

3. Wafer-Sortiervorrichtung (100) nach Anspruch 1 oder 2, wobei der Haupttransportpfad (1) mindestens zwei Abzweigungen (2) umfasst, die entlang des Haupttransportpfades (1) hintereinander angeordnet sind, wobei jede der mindestens zwei Abzweigungen (2) eine verlangsamende Förderstrecke (12) umfasst, die einen Abschnitt des Haupttransportpfades (1) bildet und mit der Steuervorrichtung (8) kommuniziert, wobei die Steuervorrichtung (8) so konfiguriert ist, dass sie die verlangsamenden Förderstrecken (12) der mindestens zwei Abzweigungen (2) so steuert, bevorzugt separat steuert, dass die verlangsamenden Förderstrecken (12) mit unterschiedlichen Geschwindigkeiten, Verlangsamungen und/oder Beschleunigungen angetrieben werden können, wobei bevorzugt die verlangsamende Förderstrecke (12) einer Abzweigung (2) mit einer anderen Geschwindigkeit, Verlangsamung und/oder Beschleunigung als die verlangsamende Förderstrecke (12) einer anderen Abzweigung (2) angetrieben werden kann.

4. Wafer-Sortiervorrichtung (100) nach einem der vorangehenden Ansprüche, wobei sich die verlangsamende Förderstrecke (12) und/oder die Abzweig-Förderstrecke (13) mindestens in einem Bereich der Abzweigung (2), bevorzugt durch die Abzweigung (2) hindurch, erstrecken.

5. Wafer-Sortiervorrichtung (100) nach einem der vorangehenden Ansprüche, wobei sich ein weiterer Abschnitt (7) der verlangsamenden Förderstrecke (12) stromabwärts der Abzweig-Förderstrecke (13) erstreckt und/oder wobei sich ein weiterer Abschnitt (6) der verlangsamenden Förderstrecke (12) zwischen Förderbändern der Abzweig-Förderstrecke (13) erstreckt und/oder wobei die beschleunigende Förderstrecke und/oder die verlangsamende Förderstrecke und/oder die Abzweig-Förderstrecke mindestens ein umlaufendes Band, bevorzugt mindestens zwei parallel verlaufende umlaufende Bänder, umfassen.

6. Wafer-Sortiervorrichtung (100) nach einem der vorangehenden Ansprüche, wobei die Wafer-Transportvorrichtung mindestens eine beschleunigende Förderstrecke (14) umfasst, die einen Abschnitt des Haupttransportpfades (1) bildet, wobei die beschleunigende Förderstrecke (14) stromaufwärts einer verlangsamenden Förderstrecke (12) angeordnet ist und mit der Steuervorrichtung (8) kommuniziert, wobei die Steuervorrichtung (8) dafür konfiguriert ist, einen Wafer durch Erhöhen der Geschwindigkeit der beschleunigenden Förderstrecke (14) zu beschleunigen, und/oder wobei die beschleunigende Förderstrecke (14) integral mit der verlangsamenden Förderstrecke (12) ausgebildet ist.

7. Wafer-Sortiervorrichtung (100) nach einem der vorangehenden Ansprüche, wobei die Wafer-Transportvorrichtung (10) eine Verschiebevorrichtung (16) umfasst,
mit deren Hilfe die Transportebene der verlangsamenden Förderstrecke (12) und die Transportebene der Abzweig-Förderstrecke (13) in vertikaler Richtung relativ zueinander verschoben werden können, und/oder
mit deren Hilfe die Transportebene der verlangsamenden Förderstrecke (12) und die Transportebene der beschleunigenden Förderstrecke (14) in vertikaler Richtung relativ zueinander verschoben werden können, wobei bevorzugt die Verschiebevorrichtung (16) mit der Steuervorrichtung (8) kommuniziert, wobei die Steuervorrichtung (8) so konfiguriert ist, dass sie die Verschiebevorrichtung (16) so steuert, dass die Transportebenen relativ zueinander verschoben werden, nachdem - bevorzugt erst nachdem - die Transportgeschwindigkeit eines Wafers, der sich der Abzweigung (2) nähert, unter einen Schwellenwert verlangsamt wurde oder null erreicht hat.

8. Wafer-Sortiervorrichtung (100) nach einem der vorangehenden Ansprüche, wobei die Transportebene der verlangsamenden Förderstrecke (12) relativ zur Transportebene der Abzweig-Förderstrecke (13) abgesenkt werden kann, und/oder
wobei die Transportebene der verlangsamenden Förderstrecke (12) relativ zur Transportebene der beschleunigenden Förderstrecke (14) abgesenkt werden kann.

9. Wafer-Sortiervorrichtung (100) nach einem der vorangehenden Ansprüche, wobei in einer ersten relativen Position die Transportebene der beschleunigenden Förderstrecke (14) und die Transportebene der verlangsamenden Förderstrecke (12) im Wesentlichen innerhalb derselben Ebene liegen, und/oder
wobei die Transportebene der Abzweig-Förderstrecke (13) auf einer niedrigeren Höhe angeordnet ist als die Transportebene der beschleunigenden Förderstrecke (14).

10. Verfahren zum Sortieren von Wafern (9) mittels einer Wafer-Sortiervorrichtung (100) nach einem der vorangehenden Ansprüche, das die folgenden Schritte umfasst:
(a) Transportieren von Wafern (9) nacheinander entlang eines Haupttransportpfades (1),
(d) selektives Transferieren von Wafern (9) von dem Haupttransportpfad (1) zu mindestens einem Abzweig-Transportpfad (3, 4) über mindestens eine im Haupttransportpfad (1) angeordnete Abzweigung (2),
**dadurch gekennzeichnet, dass** das Verfahren zwischen Schritt (a) und Schritt (d) des Weiteren folgenden Schritt umfasst:
(c) Verlangsamen von Wafern (9), die sich der Abzweigung (2) nähern, an der sie den Haupttransportpfad (1) verlassen,
wobei bevorzugt Schritt (c) durch Verringern, bevorzugt kontinuierliches Verringern, der Transportgeschwindigkeit einer verlangsamenden Förderstrecke (12) durchgeführt wird.

11. Verfahren nach Anspruch 10, wobei der Haupttransportpfad (1) mindestens zwei Abzweigungen (2) umfasst, die entlang des Haupttransportpfades (1) hintereinander angeordnet sind, wobei jede der mindestens zwei Abzweigungen (2) eine verlangsamende Förderstrecke (12) umfasst, die einen Abschnitt des Haupttransportpfades (1) bildet und mit der Steuervorrichtung (8) kommuniziert, wobei die Steuervorrichtung (8) die verlangsamenden Förderstrecken der mindestens zwei Abzweigungen (2) separat so steuert, dass die verlangsamenden Förderstrecken (12) mit unterschiedlichen Geschwindigkeiten, Verlangsamungen und/oder Beschleunigungen angetrieben werden können, wobei bevorzugt die verlangsamende Förderstrecke (12) einer Abzweigung (2) mit einer anderen Geschwindigkeit, Verlangsamung und/oder Beschleunigung als die verlangsamende Förderstrecke (12) einer anderen Abzweigung (2) angetrieben werden kann.

12. Verfahren nach Anspruch 10 oder 11,
wobei in Schritt (c) die Wafer von einer ersten Transportgeschwindigkeit auf eine Geschwindigkeit verlangsamt werden, die niedriger als 30 %, bevorzugt niedriger als 10 %, der ersten Transportgeschwindigkeit ist, wenn sie die Abzweigposition erreicht haben, wobei bevorzugt die erste Transportgeschwindigkeit jene Geschwindigkeit ist, mit der die Wafer (9) zu der verlangsamenden Förderstrecke (12) transferiert werden, und/oder wobei in Schritt (c) die Wafer auf eine Geschwindigkeit von null verlangsamt werden, wenn sie die Abzweigposition erreicht haben.

13. Verfahren nach einem der Ansprüche 10 bis 12, wobei das Verfahren zwischen Schritt (a) und Schritt (c) des Weiteren folgenden Schritt umfasst: (b) Beschleunigen der Wafer.

14. Verfahren nach einem der Ansprüche 10 bis 13, wobei Schritt (a) mittels einer ersten Förderstrecke (11) durchgeführt wird und Schritt (c) mittels einer verlangsamenden Förderstrecke (12) durchgeführt wird, wobei die Transportgeschwindigkeit der verlangsamenden Förderstrecke (12) unabhängig von der Transportgeschwindigkeit der ersten Förderstrecke (11) gesteuert wird.

15. Verfahren nach einem der Ansprüche 10 bis 14, wobei Schritt (d) das Absenken der Transportebene der verlangsamenden Förderstrecke (12) mindestens auf die Höhe der Transportebene einer Abzweig-Förderstrecke (13) oder das Anheben der Transportebene der Abzweig-Förderstrecke (13) mindestens auf die - bevorzugt höher als die - Höhe der Transportebene der verlangsamenden Förderstrecke (12) umfasst,
wobei die Transportrichtung der Abzweig-Förderstrecke (13) quer, bevorzugt im rechten Winkel, zur Transportrichtung der verlangsamenden Förderstrecke (12) verläuft, wobei bevorzugt die Transportebene der verlangsamenden Förderstrecke (12) und die Transportebene der Abzweig-Förderstrecke (13) relativ zueinander verschoben werden, nachdem - bevorzugt erst nachdem - die Transportgeschwindigkeit eines Wafers, der sich der Abzweigung (2) nähert, unter einen Schwellenwert verlangsamt wurde oder null erreicht hat, und/oder
wobei bevorzugt die Abzweig-Förderstrecke (13) die verlangsamende Förderstrecke (12) quert.

## Revendications

1. Appareil de tri de plaquettes (100) comportant un dispositif de transport de plaquettes (10), lequel comprend
- un trajet de transport principal (1) comprenant au moins une bifurcation (2),
- au moins un trajet de transport de bifurcation (3, 4) s'étendant à partir de l'au moins bifurcation (2) et
- un dispositif de commande (8) destiné à commander le transport de plaquettes (9),
dans lequel l'au moins une bifurcation (2) comprend un convoyeur de ralentissement (12) formant une section du trajet de transport principal (1) et communiquant avec le dispositif de commande (8), le dispositif de commande (8) étant configuré pour ralentir sélectivement une plaquette (9) s'approchant de ladite bifurcation (2) en réduisant la vitesse de transport du convoyeur de ralentissement (12),
**caractérisé en ce que** le convoyeur de ralentissement (12) comprend au moins deux sections (5, 6, 7),
dans lequel une première section (5) s'étend en amont d'un convoyeur de bifurcation (13)
et/ou dans lequel le convoyeur de ralentissement (12) comprend au moins une courroie de transport guidée au moins une fois sous un plan de transport du convoyeur de bifurcation (13) entre une première section (5) et une section supplémentaire (6, 7).

2. Appareil de tri de plaquettes (100) selon la revendication 1, dans lequel le convoyeur de bifurcation (13) est constitué d'au moins une bifurcation (2) et forme une section du trajet de transport de bifurcation (3, 4), dans lequel la direction de transport du convoyeur de bifurcation (13) est transversale, de préférence perpendiculairement, à la direction de transport du convoyeur de ralentissement (12).

3. Appareil de tri de plaquettes (100) selon la revendication 1 ou 2, dans lequel le trajet de transport principal (1) comprend au moins deux bifurcations (2) disposées l'une après l'autre le long du trajet de transport principal (1), dans lequel chacune parmi les au moins deux bifurcations (2) comprend un convoyeur de ralentissement (12) formant une section du trajet de transport principal (1) et communiquant avec le dispositif de commande (8), dans lequel le dispositif de commande (8) est configuré pour commander, de préférence pour commander séparément, les convoyeurs de ralentissement (12) des au moins deux bifurcations (2), de telle façon que les convoyeurs de ralentissement (12) peuvent être entraînés selon des vitesses, des ralentissements et/ou des accélérations différent(e)s, dans lequel le convoyeur de ralentissement (12) d'une bifurcation (2) peut de préférence être entraîné selon une vitesse, un ralentissement et/ou une accélération différent(e) par rapport au convoyeur de ralentissement (12) d'une autre bifurcation (2).

4. Appareil de tri de plaquettes (100) selon l'une des revendications précédentes, dans lequel le convoyeur de ralentissement (12) et/ou le convoyeur de bifurcation (13) s'étend(end) au moins dans une zone de la bifurcation (2), de préférence à travers la bifurcation (2) .

5. Appareil de tri de plaquettes (100) selon l'une des revendications précédentes, dans lequel une autre section (7) du convoyeur de ralentissement (12) s'étend en aval du convoyeur de bifurcation (13) et/ou dans lequel une autre section (6) du convoyeur de ralentissement (12) s'étend entre des courroies de transport du convoyeur de bifurcation (13) et/ou dans lequel le convoyeur d'accélération et/ou le convoyeur de ralentissement et/ou le convoyeur de bifurcation comprend/comprennent au moins une courroie de circulation, de préférence au moins deux courroies de circulation s'étendant parallèlement.

6. Appareil de tri de plaquettes (100) selon l'une des revendications précédentes, dans lequel le dispositif de transport de plaquettes comprend au moins un convoyeur d'accélération (14) formant une section du trajet de transport principal (1), dans lequel le convoyeur d'accélération (14) est disposé en amont d'un convoyeur de ralentissement (12) et communique avec le dispositif de commande (8), dans lequel le dispositif de commande (8) est configuré pour faire accélérer une plaquette en augmentant la vitesse du convoyeur d'accélération (14), et/ou dans lequel le convoyeur d'accélération (14) est formé intégralement avec le convoyeur de ralentissement (12).

7. Appareil de tri de plaquettes (100) selon l'une des revendications précédentes, dans lequel le dispositif de transport de plaquettes (10) comprend un dispositif de décalage (16)
- au moyen duquel le plan de transport du convoyeur de ralentissement (12) et le plan de transport du convoyeur de bifurcation (13) peuvent être décalés l'un par rapport à l'autre dans la direction verticale,
et/ou au moyen duquel le plan de transport du convoyeur de ralentissement (12) et le plan de transport du convoyeur d'accélération (14) peuvent être décalés l'un par rapport à l'autre dans la direction verticale,
dans lequel le dispositif de décalage (16) communique avec le dispositif de commande (8), dans lequel le dispositif de commande (8) est configuré pour commander le dispositif de décalage (16) de telle façon que les plans de transport sont décalés les uns par rapport aux autres après, de préférence seulement après, la réduction de la vitesse de transport d'une plaquette s'approchant de la bifurcation (2) en-dessous d'un seuil ou à zéro.

8. Appareil de tri de plaquettes (100) selon l'une des revendications précédentes, dans lequel le plan de transport du convoyeur de ralentissement (12) peut être abaissé par rapport au plan de transport du convoyeur de bifurcation (13),
et/ou dans lequel le plan de transport du convoyeur de ralentissement (12) peut être abaissé par rapport au plan de transport du convoyeur d'accélération (14).

9. Appareil de tri de plaquettes (100) selon l'une des revendications précédentes, dans lequel, dans une première position relative, le plan de transport du convoyeur d'accélération (14) et le plan de transport du convoyeur de ralentissement (12) s'étendent essentiellement dans le même plan,
et/ou dans lequel le plan de transport du convoyeur de bifurcation (13) est disposé à une hauteur plus basse que le plan de transport du convoyeur d'accélération (14) .

10. Procédé de tri de plaquettes (9) au moyen d'un appareil de tri de plaquettes (100) selon l'une des revendications précédentes, comprenant les étapes suivantes :
(a) transport de plaquettes (9) les après les autres le long d'un trajet de transport principal (1),
(d) transfert sélectif de plaquettes (9) à partir du trajet de transport principal (1) vers au moins un trajet de transport de bifurcation (3, 4) par le biais d'au moins une bifurcation (2) disposée dans le trajet de transport principal (1),
**caractérisé en ce qu'**entre l'étape (a) et l'étape (d), le procédé comprend en outre l'étape suivante :
(c) le ralentissement de plaquettes (9) s'approchant de la bifurcation (2) où elles quittent le trajet de transport principal (1),
dans lequel l'étape (c) est de préférence réalisée en réduisant, de préférence en réduisant de façon continue, la vitesse de transport d'un convoyeur de ralentissement (12).

11. Procédé selon la revendication 10, dans lequel le trajet de transport principal (1) comprend au moins deux bifurcations (2) disposées l'une après l'autre le long du trajet de transport principal (1), dans lequel chacune parmi les au moins deux bifurcations (2) comprend un convoyeur de ralentissement (12) formant une section du trajet de transport principal (1) et communiquant avec le dispositif de commande (8), dans lequel le dispositif de commande (8) commande séparément les convoyeurs de ralentissement des au moins deux bifurcations (2), de telle façon que les convoyeurs de ralentissement (12) peuvent être entraînés selon des vitesses, des ralentissements et/ou des accélérations différent(e)s, dans lequel le convoyeur de ralentissement (12) d'une bifurcation (2) peut de préférence être entraîné selon une vitesse, un ralentissement et/ou une accélération différent(e) par rapport au convoyeur de ralentissement (12) d'une autre bifurcation (2).

12. Procédé selon la revendication 10 ou 11,
dans lequel, dans l'étape (c), les plaquettes sont ralenties à partir d'une première vitesse de transport, à une vitesse inférieure à 30 %, de préférence inférieure à 10 %, de la première vitesse de transport, lorsque celles-ci ont atteint la position de bifurcation, dans lequel la première vitesse de transport est de préférence la vitesse à laquelle les plaquettes (9) sont transférées vers le convoyeur de ralentissement (12), et/ou dans lequel, dans l'étape (c), les plaquettes sont ralenties à une vitesse nulle lorsque celles-ci ont atteint la position de bifurcation.

13. Procédé selon l'une des revendications 10 à 12, dans lequel, entre l'étape (a) et l'étape (c), le procédé comprend en outre l'étapes suivante :
(b) accélération des plaquettes.

14. Procédé selon l'une des revendications 10 à 13, dans lequel l'étape (a) est exécutée à l'aide d'un premier convoyeur (11) et l'étape (c) est exécutée à l'aide d'un convoyeur de ralentissement (12), dans lequel la vitesse de transport du convoyeur de ralentissement (12) est commandée indépendamment de la vitesse de transport du premier convoyeur (11).

15. Procédé selon l'une des revendications 10 à 14, dans lequel l'étape (d) comprend l'abaissement du plan de transport du convoyeur de ralentissement (12) au moins au niveau du plan de transport d'un convoyeur de bifurcation (13) ou le relèvement du plan de transport du convoyeur de bifurcation (13) au moins au niveau du plan de transport du convoyeur de ralentissement (12), de préférence au-delà de celui-ci, dans lequel la direction de transport du convoyeur de bifurcation (13) est transversale, de préférence perpendiculaire, à la direction de transport du convoyeur de ralentissement (12),
dans lequel le plan de transport du convoyeur de ralentissement (12) et le plan de transport du convoyeur de bifurcation (13) sont décalés l'un par rapport à l'autre après, de préférence seulement après, la réduction de la vitesse de transport d'une plaquette s'approchant de la bifurcation (2) en-dessous d'un seuil ou à zéro,
et/ou dans lequel le convoyeur de bifurcation (13) traverse de préférence le convoyeur de ralentissement (12) .
